(19) Europäisches Patentamt

European Patent Office

Office européen des brevets

(11) **EP 1 632 781 A1**

(12) **EUROPEAN PATENT APPLICATION**

(43) Date of publication:
**08.03.2006 Bulletin 2006/10**

(51) Int Cl.:
***G01R 31/36*** (2006.01)

(21) Application number: **04255319.8**

(22) Date of filing: **02.09.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Delphi Technologies, Inc.**
**Troy, MI 48007 (US)**

(72) Inventor: **Baur, Peter**
**54295 Trier (DE)**

(74) Representative: **Jones, Keith William et al**
**Murgitroyd & Company**
**Scotland House**
**165-169 Scotland Street**
**Glasgow G5 8PL (GB)**

(54) **Method and apparatus for battery capacity detection**

(57) The invention teaches a method for battery capacity detection as well as an apparatus provided to perform that method where the battery (10) is discharged for a predetermined amount of time under the control of a battery monitoring controller (20) and where the discharged energy and an open circuit voltage upon starting and ending the discharge is determined and the capacity is calculated according to the determined values.

*Fig. 1*

**Description**

The present invention relates to a method for battery capacity detection, especially a battery used in or for use in a vehicle such as an automobile, and to an apparatus provided to accomplish the method.

Statistics of so-called vehicle "walk home failures", i.e failures that result in the vehicle driver having to walk home, identify problems with the battery charging system as a significant root cause. The increasing number of electrical components in modern automobiles, both for comfort and safety, require more and more electric energy. To increase the reliability of such electric systems a battery / energy monitoring system is required. Simple battery monitoring by some kind of battery voltage observation and interpretation provides very limited information about real battery capacity. More sophisticated systems have a current sensor to integrate and accumulate the charge- and discharge currents to determine the state of charge (SOC) of the battery. This does not capture the loss of battery capacity due to ageing / degradation.

The object of the present invention is to overcome the problems and drawbacks described above.

This is achieved by carrying out the method having the features disclosed in claim 1 and by an apparatus provided to perform that method having the features disclosed in claim 5.

Said method for detecting or observing the capacity of a battery, especially a battery used in a vehicle, comprises the steps of:

evaluating the open circuit value of the battery and storing said evaluated open circuit value as a first open circuit value;
discharging the battery for a predetermined amount of time and evaluating the energy discharged;
evaluating the open circuit value of the battery after said discharging step and storing said evaluated open circuit value as a second open circuit value;
calculating the capacity of the battery according to the discharged energy and the difference between the first and the second open circuit value.

Said apparatus provided to perform the method comprises
an electrical connection to the battery to be observed,
means for discharging the battery,
means for starting and ending said discharge of the battery,
means for measuring the energy discharged from the battery,
means for measuring the open circuit value of the battery at or before starting the discharge of the battery and at or after ending the discharge of the battery and
means for calculation the capacity of the battery according to the discharged energy and a difference between a open circuit voltage measurable at or before starting the discharge of the battery and at or after ending the discharge of the battery.

The essential advantages of the invention are that a reliable battery capacity is provided, where both the method for obtaining the capacity and the apparatus performing that method are easy to implement and rely on components which are already present in the battery system of a vehicle or can easily and without incurring unduly costs be added to the system.

The dependent claims outline advantageous forms of embodiment of the method or apparatus according to the invention.

The present invention is particularly concerned with providing such battery capacity detection in vehicles with dual voltage/dual battery systems that use a DC/DC converter to exchange electric energy between the two batteries.

Obviously, other connection arrangements can be envisaged.

Other features and advantages of the present invention will appear from the following description of a preferred embodiment of the invention, given as a non-limiting example, illustrated in the drawings. All the elements which are not required for the immediate understanding of the invention are omitted. In the drawings, the same elements are provided with the same reference numerals in the various figures, in which:

FIG 1 is a schematical circuit diagram of a dual battery system in a vehicle and
FIG 2 is a characteristic curve showing the relation between open circuit voltage of the battery and its state of charge.

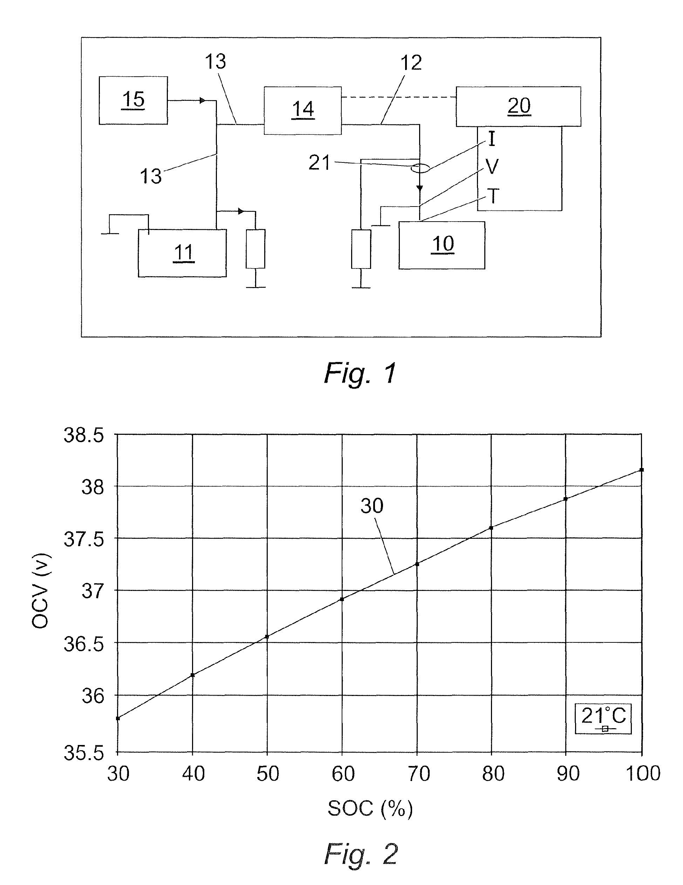

FIG 1 is a schematic circuit diagram of a dual battery system in a vehicle. The system comprises a first and a second battery 10, 11. The first battery 10 is the battery whose capacity is to be detected. Both the batteries 10, 11 are electrically connected by means of appropriate wiring 12, 13 and a DC/DC converter 14 provided to exchange electrical energy between the batteries 10, 11. As a means to recharge the batteries 10, 11, the system further comprises a generator 15.

A battery monitoring controller 20 provided to accomplish the steps of the method for detecting or observing the capacity of the first battery 10, is connected to the DC/DC converter 14 and to sensors provided for determining the current discharged from the first battery 10 (current sensor 21), the voltage provided by the first battery 10 and the temperature of the first battery 10. The connection between the battery monitoring controller 20 (controller 20 hereinafter) and the DC/DC converter 14 (converter 14 hereinafter), as a means for discharging the battery 10, enables the controller 20 to discharge the first battery 10 for a predetermined amount of time by triggering the converter 14 to act as a switch closing and opening the electrical connection via wiring 12, 13 between the batteries 10, 11. As soon as the electrical connection is established, electrical energy starts to shift from the first battery 10 to the second battery 11. The controller 20 therefore is a means for starting and ending said discharge of the battery and is enabled to initiate and terminate the electrical connection between both the batteries 10, 11 and is accordingly enabled to initiate and terminate the predetermined amount of time during which the electrical energy is transferred. Instead of shifting the electrical energy to the second battery 11, a grounded resistor (not shown) may be employed. The shifted energy then, of course, is not stored but lost due to the consumption when passing through the resistor.

Whenever the detection of the capacity of the first battery is required an external trigger signal (not shown) is sent to the controller 20 causing the controller 20 to determine the open circuit voltage (OCV) of the first battery 10, by means of the voltage sensor (not shown), and to store the determined open circuit voltage as a first open circuit voltage. Next the controller 20 will trigger the converter 14 to electrically close the connection 12, 13 between the batteries 10, 11 in order to enable the transfer of electrical energy from the first to the second battery 10, 11. The energy discharged from the first battery, i.e. the current, is determined by means of measuring the energy discharged from the battery, e.g. by means of the current sensor 21 and integrated over the time. As soon as the predetermined amount of time has elapsed the controller 20 triggers the converter 14 to electrically open the connection 12, 13 between the batteries 10, 11 in order to prevent further transfer of electrical energy. Next the controller will determine the open circuit voltage (OCV) of the first battery 10 again and store the determined open circuit voltage as a second open circuit voltage. Finally the capacity of the first battery 10 is calculated according to the discharged energy and the difference between the first and the second open circuit value. More specifically, the capacity is calculated according to the integral over the current discharged from the battery for the duration of said predetermined amount of time and said difference between the first and second open circuit value. In order to perform said calculation the controller 20 comprises calculation means (not shown) such as a microprocessor etc.

FIG 2 depicts a characteristic curve 30 showing the relation between the open circuit voltage of a battery, i.e. the first battery 10, and its state of charge. The open circuit voltage (OCV) is given on the ordinate and the state of charge (SOC) is given on the abscissa. It is apparent that the characteristic curve 30 is essentially a straight line, thus the relation between the open circuit voltage and the state of charge is essentially linear. The depicted characteristic curve 30 is the curve valid for a certain temperature or temperature range of the first battery 10. The example of FIG 2 shows the characteristic curve 30 valid for a temperature of 21 degrees Celsius. The relevant temperature is determined by means of a temperature sensor (not shown) under control of the controller 20 (FIG 1). According to the relevant temperature the controller 20 calculates or estimates the respective characteristic curve 30 or selects the respective characteristic curve from a set of stored characteristic curves.

When calculating the capacity of the first battery 10 the characteristic is beneficially employed in that a first and second state of charge value is obtained from the first and second open circuit value determined when initiating and terminating the transfer of electrical energy from the first battery 10. Both the open circuit values and the state of charge value are reciprocally related via the characteristic curve 30. When employing the characteristic curve 30 the capacity of the first battery can be calculated by dividing the amount of electrical energy discharged from the first battery, i.e. the discharged Ampere hours, and the difference between the first and second state of charge values given.

$$Capacity \sim Ampere\ hours\ /\ (\ first\ SOC\ -\ second\ SOC)$$

Since the state of charge values are given as percentage values the proper formula would be

$$Capacity = Ampere\ hours\ /\ (\ first\ SOC\ [\%]\ -\ second\ SOC\ [\%]\ )\ *\ 100.$$

Owing to the above the invention can be described in short form as a new method for battery capacity detection and a corresponding apparatus provided to perform that method preferably for vehicles with dual voltage / dual battery systems that use a DC/DC converter 14 to exchange electric energy between the two batteries 10, 11. The method will shift a small quantity of electric energy from the first battery 10 to the second battery 11 by the DC/DC converter 14 to decrease the SOC in the first battery 10. The transferred current will be integrated and the Open Circuit Voltage (OCV) will be detected before and after the energy shift. The SOC of a battery in % is related to its OCV. This relation, however, does not take into account battery capacity degradation due to ageing or abuse of the battery. The discharged Ampere hours in combination with the detected OCV difference allows the determination of the absolute capacity of the battery in this moment of time.

Components needed to perform this method:

- two batteries 10, 11 (e.g. applications with 14V /42V for safety critical tasks (x-by-wire) or high power loads
- DC-DC converter 14 (e.g. applications with 14V /42V architecture)
- free controller capacity (either extra battery controller 20 or within existing vehicle controller)
- sensors for battery current, voltage and temperature connected to the controller 20.

This energy transfer can be executed upon different criterias that might influence real battery capacity like accumulated Amp. hours discharged or time since last transfer or extreme operating temperatures or a combination of all

Although a preferred embodiment of the invention has been illustrated and described herein, it is recognised that changes and variations may be made without departing from the invention as set forth in the claims.

## Claims

1.  A method for detecting or observing the capacity of a battery, especially a battery (10) used in a vehicle, said method comprising the steps of:

    evaluating the open circuit value of the battery (10) and storing said evaluated open circuit value as a first open circuit value;
    discharging the battery (10) for a predetermined amount of time and evaluating the energy discharged;
    evaluating the open circuit value of the battery (10) after said discharging step and storing said evaluated open circuit value as a second open circuit value;
    calculating the capacity of the battery (10) according to the discharged energy and the difference between the first and the second open circuit value.

2.  A method according to claim 1, wherein the step of calculating the capacity of the battery (10) comprises the steps of determining a first and second state of charge value of the battery (10) according to the first and second open circuit value, where the first and second state of charge value is related to the first and second open circuit value by a characteristic curve (30) and
    calculating the capacity of the battery (10) according to the discharged energy and the difference between the first and the second state of charge value.

3.  A method according to claim 1 or claim 2, wherein the step of discharging the battery (10) for a predetermined amount of time and evaluating the energy discharged comprises the step of
    evaluating the integral over the current discharged from the battery and by means of a current sensor (21) for the duration of said predetermined amount of time.

4.  A method according to claim 2 and claim 3, wherein the step of calculating the capacity of the battery (10) comprises the step of
    calculating the capacity of the battery (10) according to the value of said integral and the difference between the first and second state of charge value.

5.  An apparatus for detecting or observing the capacity of a battery (10), especially a battery (10) used in a vehicle, comprising
    an electrical connection (12) to the battery (10) to be observed,
    means (14) for discharging the battery (10),
    means (20) for starting and ending said discharge of the battery (10),
    means (21) for measuring the energy discharged from the battery (10),
    means for measuring the open circuit value of the battery at or before starting the discharge of the battery (10) and at or after ending the discharge of the battery (10) and
    means for calculation the capacity of the battery (10) according to the discharged energy and a difference between an open circuit voltage measurable at or before starting the discharge of the battery (10) and at or after ending the discharge of the battery (10).

6. An apparatus according to claim 5, comprising a DC/DC converter (14).

7. An apparatus according to claim 5 or claim 6, wherein the means for discharging the battery comprises a second battery (11).

8. An spparatus according to claim 5 to claim 7, wherein the means for discharging the battery comprises a current sensor (21).

*Fig. 1*

*Fig. 2*

**European Patent Office**

## EUROPEAN SEARCH REPORT

Application Number

EP 04 25 5319

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN vol. 2002, no. 12, 12 December 2002 (2002-12-12) -& JP 2002 243813 A (NISSAN MOTOR CO LTD), 28 August 2002 (2002-08-28) See computer translation on http://dossier1.ipdl.ncipi.go.jp/AIPN/aipn_call_transl.ipdl?N0000=7413&N0120=01&N2001=2&N3001=2002-243813 * the whole document * | 1-8 | G01R31/36 |
| X | PATENT ABSTRACTS OF JAPAN vol. 2000, no. 12, 3 January 2001 (2001-01-03) -& JP 2000 261901 A (NISSAN MOTOR CO LTD), 22 September 2000 (2000-09-22) See computer translation on http://dossier1.ipdl.ncipi.go.jp/AIPN/aipn_call_transl.ipdl?N0000=7413&N0120=01&N2001=2&N3001=2000-261901 * the whole document * | 1-8 | |
| X | PATENT ABSTRACTS OF JAPAN vol. 1995, no. 10, 30 November 1995 (1995-11-30) -& JP 07 183050 A (SHIN KOBE ELECTRIC MACH CO LTD), 21 July 1995 (1995-07-21) * abstract * | 1,5 | TECHNICAL FIELDS SEARCHED (IPC) G01R |
| X | US 6 094 052 A (ARAI ET AL) 25 July 2000 (2000-07-25) * abstract; figure 1 * | 1,5 | |
| X | US 5 744 963 A (ARAI ET AL) 28 April 1998 (1998-04-28) * claim 5; figure 1 * | 1,5 | |
| | -/-- | | |

The present search report has been drawn up for all claims

| Place of search | Date of completion of the search | Examiner |
|---|---|---|
| Munich | 29 November 2005 | Hijazi, A |

EPO FORM 1503 03.82 (P04C01)

**European Patent Office**

**EUROPEAN SEARCH REPORT**

Application Number

EP 04 25 5319

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 314 992 A (YAMAHA HATSUDOKI KABUSHIKI KAISHA) 28 May 2003 (2003-05-28) <br> * paragraph [0150] - paragraph [0160] * <br> ----- | 1,5 | |
| A | PATENT ABSTRACTS OF JAPAN <br> vol. 2002, no. 03, <br> 3 April 2002 (2002-04-03) <br> -& JP 2001 333501 A (DENSO CORP), <br> 30 November 2001 (2001-11-30) <br> * abstract * <br> ----- | 7 | |
| A | PATENT ABSTRACTS OF JAPAN <br> vol. 018, no. 332 (E-1567), <br> 23 June 1994 (1994-06-23) <br> -& JP 06 078463 A (HITACHI LTD), <br> 18 March 1994 (1994-03-18) <br> * abstract * <br> ----- | 7 | |

TECHNICAL FIELDS SEARCHED (IPC)

The present search report has been drawn up for all claims

| Place of search | Date of completion of the search | Examiner |
|---|---|---|
| Munich | 29 November 2005 | Hijazi, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 25 5319

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2005

| Patent document cited in search report | Publication date | Patent family member(s) | | Publication date |
|---|---|---|---|---|
| JP 2002243813 A | 28-08-2002 | NONE | | |
| JP 2000261901 A | 22-09-2000 | JP | 3395694 B2 | 14-04-2003 |
| JP 07183050 A | 21-07-1995 | JP | 2979938 B2 | 22-11-1999 |
| US 6094052 A | 25-07-2000 | JP | 3394152 B2 | 07-04-2003 |
| | | JP | 10295044 A | 04-11-1998 |
| US 5744963 A | 28-04-1998 | JP | 8240647 A | 17-09-1996 |
| EP 1314992 A | 28-05-2003 | CN | 1415973 A | 07-05-2003 |
| | | JP | 2003224901 A | 08-08-2003 |
| JP 2001333501 A | 30-11-2001 | NONE | | |
| JP 06078463 A | 18-03-1994 | DE | 4328953 A1 | 03-03-1994 |
| | | JP | 3251657 B2 | 28-01-2002 |
| | | US | 5537390 A | 16-07-1996 |

EPO FORM P0459

For more details about this annex : see Official Journal of the European Patent Office, No. 12/82